# EUROPÄISCHE PATENTSCHRIFT

(11) **EP 2 600 405 B1**
(45) Veröffentlichungstag und Bekanntmachung des Hinweises auf die Patenterteilung: **10.05.2017**
(21) Anmeldenummer: 12192190.2
(22) Anmeldetag: 12.11.2012
(51) Int. Cl.: H01L 29/872, H01L 29/47

(54) **Super trench schottky barrier schottkydiode**
Super trench Schottky barrier diode
Super diode à barrière Schottky avec tranchées

(30) Priorität: 01.12.2011 DE 102011087596
(43) Veröffentlichungstag der Anmeldung: 05.06.2013
(73) Patentinhaber: ROBERT BOSCH GMBH, 70442 Stuttgart (DE)
(72) Erfinder: Qu, Ning, 72770 Reutlingen (DE); Goerlach, Alfred, 72127 Kusterdingen (DE)

(56) Entgegenhaltungen:
- WO-A1-2006/061277
- DE-A1-102007 002 965
- DE-A1-102010 043 088
- US-A- 5 262 668

## Beschreibung

Die Erfindung betrifft eine Schottkydiode, die sich für Hochspannungsanwendungen eignet und eine niedrige Flussspannung, einen niedrigen Leckstrom und eine kleine Schaltverlustleistung aufweist.

### Stand der Technik

Für Hochspannungsanwendungen werden in der Regel Hochspannungs-PN-Dioden eingesetzt. Derartige Hochspannungs-PN-Dioden weisen in vorteilhafter Weise einen niedrigen Leckstrom sowie eine hohe Robustheit auf. Nachteile von derartigen Hochspannungs-PN-Dioden bestehen darin, dass sie eine hohe Flussspannung und eine hohe Schaltverlustleistung haben.

In einer derartigen Hochspannungs-PN-Diode wird die Spannung hauptsächlich von dem bei derartigen Dioden vorgesehenen schwach dotierten Gebiet übernommen. Im Falle eines Betriebes in Flussrichtung werden Elektronen und Löcher in das schwach dotierte Gebiet injiziert. Bei hoher Stromdichte herrscht Hochinjektion im schwach dotierten Gebiet und die Elektronen- und die Löcherdichten sind größer als die Dotierkonzentration des schwach dotierten Gebietes. Dadurch wird die Leitfähigkeit des schwach dotierten Gebietes erhöht. Dies führt in vorteilhafter Weise zu einer Reduzierung der Flussspannung. Allerdings beginnt der Strom einer Hochspannungs-PN-Diode bei Raumtemperatur erst ab etwa einer Flussspannung UF = 0,7 V zu fließen. Unter normalen Betriebsbedingungen, beispielsweise bei einer Stromdichte, die größer als 100 A/cm² ist, steigt die Flussspannung UF auf Werte an, die größer als 1 V sind. Damit ist eine entsprechend hohe, unerwünschte Verlustleistung verbunden. Da eine Hochspannungs-PN-Diode ein dickes schwach dotiertes Gebiet benötigt, ist der Spannungsabfall in Flussrichtung über dem schwach dotierten Gebiet trotz der Leitfähigkeitsmodulation relativ groß.

Die Ladungsträger (Elektronen und Löcher), die während des Betriebs in Flussrichtung in das schwach dotierte Gebiet injiziert und dort gespeichert werden, müssen beim Abschalten, beispielsweise bei einer abrupten Stromkommutierung, erst abgebaut werden, bevor die Hochspannungs-PN-Diode überhaupt in der Lage ist, wieder Sperrspannung zu übernehmen. Daher fließt der Strom bei einer abrupten Stromkommutierung zuerst in Sperrrichtung weiter, bis die gespeicherten Ladungsträger abgebaut bzw. ausgeräumt sind. Dieser Vorgang, also die Höhe und die Dauer des Ausräumstroms zum Abbau der gespeicherten Ladungsträger, ist in erster Linie von der Menge der im schwach dotierten Gebiet gespeicherten Ladungsträger bestimmt. Ein höherer und länger dauernder Ausräumstrom bedeutet eine höhere Abschaltverlustleistung.

Werden bei Hochspannungsanwendungen anstelle von Hochspannungs-PN-Dioden Hochspannungs-Schottkydioden verwendet, dann ist in vorteilhafter Weise die Abschaltverlustleistung reduziert. Eine Hochspannungs-Schottkydiode ist ein Majoriätsladungsträger-Bauelement, in dem auch bei hoher Stromdichte im Betrieb in Flussrichtung keine Hochinjektion auftritt, d. h. keine Injektion von Elektronen und Löchern in das schwach dotierte Gebiet. Da bei einer Hochspannungs-Schottkydiode keine Hochinjektion mit Leitfähigkeitsmodulation auftritt, fällt beim Betrieb mit hohen Strömen am schwach dotierten Gebiet allerdings eine hohe Spannung ab. Dies beschränkt bisher den Einsatz von hochsperrenden Schottkydioden auf sehr kleine Ströme. Weitere Nachteile von Hochspannungs-Schottkydioden sind die hohen Leckströme, insbesondere bei Hochtemperatur, sowie deren starke Spannungsabhängigkeit wegen des Barrier-Lowering-Effekts.

WO 2006/061277 (Robert Bosch Gmbh) beschreibt eine Trench-Schottky-Diode mit zwei verschiedenen Schottky-Barrierehöhen.

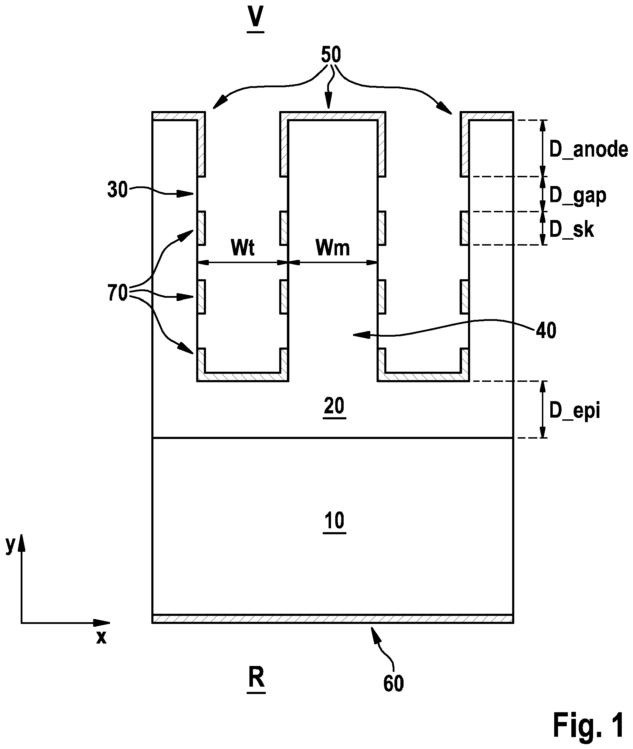

In der DE 10 2010 043 088.9 der Anmelderin ist eine Schottkydiode beschrieben, die den Vorteil einer kleinen Abschaltverlustleistung aufweist und die bei üblichen Hochspannungs-Schottkydioden auftretenden Nachteile einer hohen Flussspannung und hoher Leckströme zumindest teilweise überwindet. Eine derartige Schottkydiode, die auch als Super Trench Schottky Barrier Diode (STSBD) bezeichnet wird, ist in der Figur 1 gezeigt. Sie weist ein n⁺-Substrat 10, eine n-Epischicht 20, in die n-Epischicht 20 eingeätzte Gräben 30 (Trenches), die jeweils eine Breite Wt aufweisen und einen Abstand D_epi zum n⁺-Substrat haben, Mesabereiche 40 mit einer Breite Wm zwischen den benachbarten Gräben 30, eine als Schottky-Kontakt wirkende und als Anodenelektrode dienende Metallschicht 50 an der Vorderseite V der als Chip realisierten Schottkydiode, eine als Kathodenelektrode wirkende Metallschicht 60 an der Rückseite R des Chips und weitere Schottky-Kontakte 70 an den Wänden der Gräben 30 auf. Diese weiteren Schottky-Kontakte 70 haben in Richtung zum n⁺-Substrat 10 jeweils eine Weite D_sk und einen Abstand D_gap zum jeweils nächsten weiteren Schottky-Kontakt 70. Die Metallschicht 50 bedeckt die Trenchwände jeweils bis zu einer Tiefe D_anode und hat zum jeweils benachbarten ersten weiteren Schottky-Kontakt 70 einen Abstand D_gap. Die Schottky-Kontakte 70 an den Trenchwänden floaten. Der dem n⁺-Substrat 10 jeweils nächstliegende weitere Schottky-Kontakt 70 überdeckt jeweils einen Trenchboden. Die Anzahl der floatenden Kontakte kann beliebig gewählt werden. Bevorzugt werden wesentlich mehr Kontakte gewählt als in der Figur 1 dargestellt sind.

Bei einer derartigen STSBD dehnt sich in Sperrrichtung die Raumladungszone in der n-Epischicht 20 mit ansteigender Spannung in Richtung zum Trenchboden aus. Falls die Raumladungszone bei einer Spannung V1 den ersten gefloateten Schottky-Kontakt erreicht, wird diese Spannung V1 von dem ersten gefloateten Schottky-Kontakt übernommen. Die Raumladungszone dehnt sich mit weiter steigender Spannung in Richtung Trenchboden weiter aus. Die Spannung an dem ersten gefloateten Schottky-Kontakt bleibt unverändert.

Analog erreicht die Raumladungszone bei einer höheren Spannung Vn den n-ten gefloateten Schottky-Kontakt. Dabei übernimmt der n-te gefloatete Schottky-Kontakt die Spannung Vn. Wiederum bleibt bei weiter steigender Spannung die Spannung am n-ten gefloateten Schottky-Kontakt unverändert.

Falls die Weite D_sk und der Abstand D_gap in der STSBD-Struktur für alle weiteren Schottky-Kontakte 70 gleich gewählt sind, liegt im Mesabereich 40 eine periodisch homogene Feldverteilung vor. Die Feldverteilung im Mesabereich wiederholt sich nach einem Abstand D_sk + D_gap immer wieder, bis schließlich der Trenchboden erreicht ist. Die Spannungsverteilung im Mesabereich 40 ist dann weitgehend linear. Im Vergleich zu konventionellen Hochspannungs-PN-Dioden oder -Schottkydioden lässt sich bei der STSBD bei einer vorgegebenen Dicke des schwach dotierten Gebiets eine wesentlich höhere Spannung unterbringen.

Dadurch wird ein sehr vorteilhafter Kompromiss zwischen Durchbruchspannung, Flussspannung und Abschaltverlustleistung erzielt.

### Offenbarung der Erfindung

Eine Schottkydiode mit den im Anspruch 1 angegebenen Merkmalen weist in vorteilhafter Weise eine niedrige Flussspannung, einen niedrigen Leckstrom und eine niedrige Abschaltverlustleistung auf. Diese Vorteile werden dadurch erzielt, dass bei einer Schottkydiode, die ein n⁺-Substrat, eine n-Epischicht, in die n-Epischicht eingebrachte Gräben, die einen Abstand zum n⁺-Substrat aufweisen, Mesabereiche zwischen benachbarten Gräben und eine Metallschicht an ihrer Rückseite aufweist, wobei diese Metallschicht als Kathodenelektrode dient, an der Vorderseite der Schottkydiode eine Anodenelektrode vorgesehen ist, die zwei Metallschichten aufweist, von denen die erste einen Schottky-Kontakt bildet und die zweite unterhalb der ersten angeordnet ist und ebenfalls einen Schottky-Kontakt bildet und wobei weitere floatende Schottky-Kontakte unterhalb der zweiten Metallschicht vorgesehen sind.

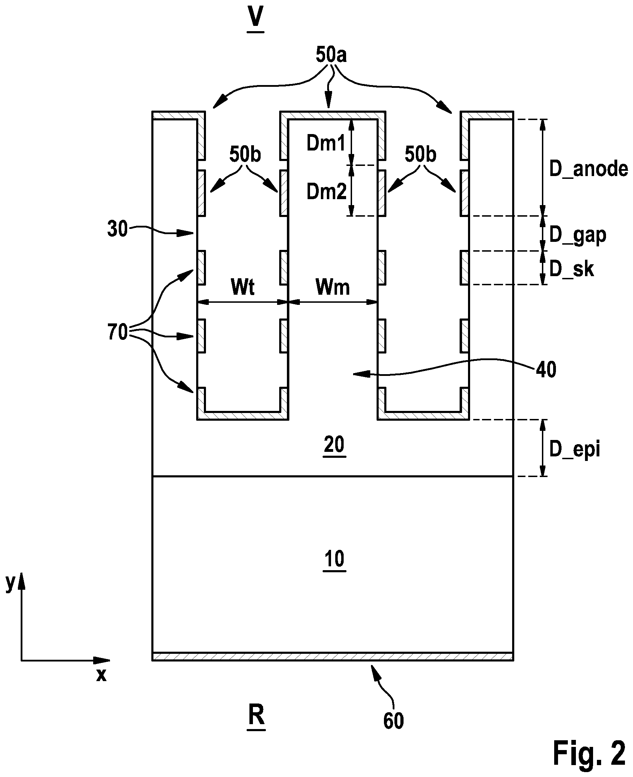

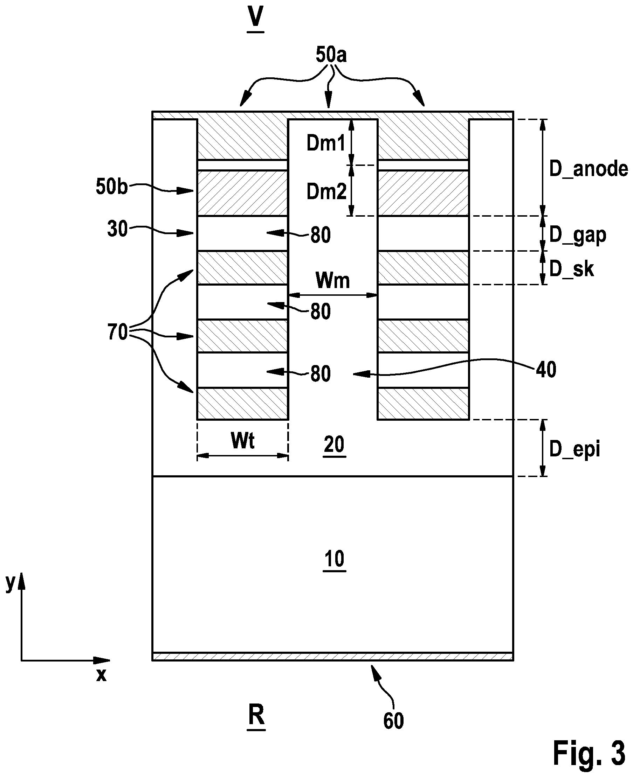

Weitere vorteilhafte Eigenschaften der Erfindung ergeben sich aus deren nachfolgender beispielhafter Erläuterung anhand der Figuren 2 und 3.

Die Figur 2 zeigt eine Schottkydiode, die nachfolgend auch als Super Trench Schottky Barrier Schottkydiode bzw. als STSBS bezeichnet wird.

Die dargestellte STSBS weist ein n⁺-Substrat 10, eine n-Epischicht 20, in die n-Epischicht 20 vorzugsweise durch Einätzen eingebrachte Gräben 30 (Trenches), Mesabereiche 40 zwischen benachbarten Gräben 30, an ihrer Rückseite R eine Metallschicht 60, an ihrer Vorderseite V eine aus zwei Metallschichten 50a und 50b, die jeweils als Schottky-Kontakt dienen, bestehende Anodenelektrode, wobei sich die Metallschicht 50a teilweise und die Metallschicht 50b vollständig längs einer Grabenseitenwand erstreckt und wobei die Metallschichten 50a und 50b galvanisch verbunden bzw. nur durch einen minimalen Abstand getrennt sind, und weitere Schottky-Kontakte 70 auf, die in der Figur 2 unterhalb der zweiten Metallschicht 50b positioniert sind und sich jeweils entlang einer Grabenseitenwand erstrecken.

Die Gräben 30 haben jeweils eine Breite Wt und einen Abstand D_epi vom n⁺-Substrat 10. Die Mesabereiche 40 haben jeweils eine Breite Wm. Die Metallschicht 60 an der Rückseite R der vorzugsweise als Chip realisierten Schottkydiode dient als Kathodenelektrode. Die weiteren Schottky-Kontakte 70, die längs der Grabenseitenwände angeordnet sind, haben eine Weite D_sk. Zwischen einander benachbarten weiteren Schottky-Kontakten 70 besteht jeweils ein Abstand D_gap. Ein Abstand D_gap besteht auch zwischen der Metallschicht 50b und dem der Metallschicht 50b benachbarten weiteren Schottky-Kontakt 70.

Die Weite der Metallschicht 50a beträgt Dm1. Die Weite der Metallschicht 50b beträgt Dm2. Die als Schottky-Kontakte wirkenden Metallschichten 50a und 50b bedecken die Seitenwände der Gräben 30 bis zu einer Tiefe D_anode. Die weiteren Schottky-Kontakte 70 an den Seitenwänden der Gräben 30 floaten. Der in der Figur 2 unterste weitere Schottky-Kontakt 70 überdeckt jeweils den Grabenboden.

Die Schottky-Kontakte 50a und 50b werden mit unterschiedlichen Barrierenhöhen realisiert. Der Schottky-Kontakt 50a an der Chipvorderseite hat vorzugsweise eine kleinere Barrierenhöhe als der Schottky-Kontakt 50b. Die floatenden Kontakte können eine andere Barrierenhöhe als die Schottky-Kontakte 50a bzw. 50b aufweisen, weisen aber bevorzugt die Barrierenhöhe des zweiten Schottky-Kontakts 50b auf.

Bei der STSBS dieser Erfindung fließen Ströme in Flussrichtung von den Schottky-Kontakten 50a und 50b als Anodenelektrode durch die Mesabereiche 40 und die Epi-Schicht 20 zwischen den Trenchböden und dem n⁺-Substrat 10 zur Metallschicht 60 an der Rückseite R des Chips, die als Kathodenelektrode dient. Über die gefloateten weiteren Schottky-Kontakte 70 werden Ströme nur weitergeleitet, da sie niederohmige Strompfade darstellen. Da der Schottky-Kontakt 50a an der Chipvorderseite V vorzugsweise eine deutlich kleinere Barrierenhöhe als der direkt darunter liegende Schottky-Kontakt 50b hat, übernimmt der Schottky-Kontakt 50a deutlich mehr Ströme. Daher wird die Flussspannung hauptsächlich von der Barrierenhöhe des Schottky-Kontakts 50a bestimmt.

In Sperrrichtung sorgt der untere Schottky-Kontakt 50b mit seiner größeren Barrierenhöhe für eine größere Ausdehnung der Raumladungszone in der n-Epischicht 20. Die Raumladungszone dehnt sich mit steigender Spannung aus und stößt bei einer Spannung, die kleiner als die Durchbruchspannung der STSBS ist, in der Mitte des Bereichs zwischen den benachbarten Gräben 30 zusammen. Dadurch werden die für hohe Sperrströme verantwortlichen Schottky-Effekte abgeschirmt und die Sperrströme reduziert. Dieser Abschirmeffekt ist stark von den Strukturparametern Wm (Abstand zwischen den Gräben), Dm1 (Weite des Schottky-Kontakts 50a an der Chipvorderseite) und Dm2 (Weite des direkt darunter liegenden Schottky-Kontakts 50b) abhängig.

Der Vorteil einer STSBS ist einerseits die Kombination der beiden Schottky-Kontakte 50a und 50b, die beide als Anodenelektrode dienen und unterschiedliche Barrierenhöhen haben und die eine gewisse Trennung der Konstruktionen bzgl. der Anforderungen von Flussspannung und Abschirmverhalten ermöglichen. Die Flussspannung UF und der Anfangswert des Leckstroms IR0 werden vorwiegend von dem Schottky-Kontakt 50a an der Chipvorderseite V mit kleinerer Barrierenhöhe beeinflusst. Je größer der Anteil von dem Schottky-Kontakt 50a ist, desto niedriger ist UF und desto höher ist IR0. Andererseits bestimmt der direkt darunter liegende Schottky-Kontakt 50b mit größerer Barrierenhöhe die Spannungsabhängigkeit des Leckstroms, die Durchbruchspannung und die Stromverteilung bei hohen Sperrströmen. Die STSBS bietet daher zusätzliche Optimierungsmöglichkeiten durch Kombination der beiden Schottky-Kontakte als Anodenelektrode. Sowohl die Weiten Dm1 und Dm2 als auch die Barrierenhöhen der beiden Schottky-Kontakte können als Parameter eingesetzt werden.

Andererseits verfügt eine STSBS ebenso wie eine STSBD den Vorteil einer fast linearen Spannungsverteilung in den Mesabereichen 40 mit Hilfe der gefloateten Schottky-Kontakte 70. Im Sperrzustand kann eine STSBS elektrisch als eine Reihenschaltung von mehreren Niederspannungsdioden aufgefasst werden. Im Vorwärtsbetrieb hingegen fällt im Unterschied zu einer gewöhnlichen Reihenschaltung von Dioden nur eine Flussspannung ab, nämlich die Flussspannung der Schottkydiode, die sich aus den Anodenmetallen 50a/50b und der n-Epischicht 20 zusammensetzt. Daher kann im Vergleich zu konventionellen Hochspannungs-PN-Dioden oder-Schottkydioden bei vergleichbaren Durchbruchsspannungen die Dotierkonzentration des Gebiets 20 bei einer STSBS deutlich höher gewählt werden, beispielsweise um einen Faktor 5 bis 10. Dies ist umso ausgeprägter, je mehr floatende Kontakte vorhanden sind. Dadurch fällt am hochohmigen Gebiet 20 wesentlich weniger Spannung ab bzw. es können bei vergleichbarer Flussspannung wesentlich höhere Flussströme fließen.

Ein Vorteil einer STSBS gemäß der Erfindung im Vergleich zu einer konventionellen Hochspannungs-Schottkydiode besteht darin, dass bei einer STSBS die Flussspannung im Bereich hoher Stromdichten wesentlich niedriger ist, da die Dotierkonzentration des Gebiets 20 wesentlich höher ist. Des Weiteren tritt bei einer STSBS ein deutlicher niedrigerer Leckstrom auf.

Ein Vorteil einer STSBS gemäß der Erfindung im Vergleich zu einer konventionellen Hochspannungs-PN-Diode besteht darin, dass die Flussspannung auch bei höheren Strömen klein bleibt. Dies ist darauf zurückzuführen, dass bei einer STSBS durch eine geeignete Wahl des Barrierenmetalls die Flussspannung gemessen bei niedrigen Stromdichten kleiner als die vergleichbare Flussspannung einer PN-Diode gewählt werden kann. Einen wesentlichen Vorteil gegenüber konventionellen Hochspannungs-PN-Dioden stellt des Weiteren das schnelle, leistungsarme Ausschaltverhalten der STSBS dar. Da die STSBS eine Schottkydiode und in Folge dessen ein Majoritätsladungsträger-Bauelement ist, ist die Abschaltverlustleistung signifikant kleiner als die einer Hochspannungs-PN-Diode.

Ein Vorteil einer STSBS gemäß der Erfindung im Vergleich zu einer STSBD besteht darin, dass eine STSBS gemäß der Erfindung zusätzlichen Spielraum bei der Auslegung der Flussspannung und des Leckstroms bietet. Dies ist darauf zurückzuführen, dass eine STSBS eine aus zwei Schottky-Kontakten bestehende Anodenelektrode aufweist, wodurch ermöglicht wird, dass diese beiden Schottky-Kontakte mit unterschiedlichen Barrierehöhen ausgelegt werden können.

Neben einer Optimierung im Hinblick auf die Anzahl der floatenden Kontakten 70 lassen sich bei der Auslegung einer STSBS in Abhängigkeit vom jeweils vorliegenden Anwendungsfall folgende Strukturparameter optimieren:
- die Weiten Dm1 und Dm2 der beiden Schottky-Kontakte 50a und 50b:
   dies ermöglicht eine Abstimmung zwischen Leckstrom und Flussspannung;
- die Weite D_sk der gefloateten Schottky-Kontakte 70 an den Grabenseitenwänden:
   dies ermöglicht eine Beeinflussung der Entkopplung der einzelnen periodischen Bereiche in den Mesabereichen 40;
- der Abstand D_gap zwischen einander benachbarten Schottky-Kontakten 70 an den Grabenseitenwänden:
   dies ermöglicht eine Beeinflussung der Linearität der Spannungsverteilung in den Mesabereichen 40;
- die Breite Wt der Gräben 30:
   dies ermöglicht eine Beeinflussung der Flussspannung;
- die Breite Wm der Mesabereiche 40:
   dies ermöglicht eine Abstimmung zwischen dem Leckstrom und der Flussspannung;
- der Abstand D_epi zwischen den Grabenböden und dem n⁺-Substrat:
   dies ermöglicht eine Abstimmung zwischen der gesamten Durchbruchspannung und der Spannung des letzten Schottky-Kontaktes im Falle eines Durchbruchs.

Die vorstehend beschriebene Erfindung stellt nach alledem eine in Trenchtechnik realisierte Hochspannungs-Schottkydiode zur Verfügung, die eine niedrige Flussspannung, einen niedrigen Flussstrom und kleine Abschaltverluste aufweist.

In einer STSBS gemäß der Erfindung wird einerseits eine Trenchstruktur mit mehreren gefloateten Schottky-Kontakten an den Grabenwänden realisiert. Dadurch bildet sich in den Mesabereichen jeweils eine periodisch homogene Feldverteilung und eine nahezu lineare Spannungsverteilung aus. Die Dotierkonzentration für eine vorgegebene Durchbruchspannung kann etwa um den Faktor 5 bis 10 höher gewählt werden als bei einer konventionellen Hochspannungs-PN-Diode oder -Schottkydiode.

Andererseits besteht die Anodenelektrode einer STSBS dieser Erfindung aus einem Schottky-Kontakt an der Chipvorderseite mit einer kleineren Barrierenhöhe und einem direkt darunter liegenden Schottky-Kontakt mit einer größeren Barrierenhöhe. Während der Schottky-Kontakt mit der kleineren Barrierenhöhe die Flussspannung bestimmt, verbessert der Schottky-Kontakt mit der größeren Barrierenhöhe die Spannungsabhängigkeit des Leckstroms.

Eine Schottkydiode gemäß der Erfindung kann alternativ zu der oben beschriebenen Ausführungsform auch dadurch realisiert werden, dass alle ihre oben beschriebenen Halbleiterschichten den jeweils entgegengesetzten Leitfähigkeitstyp aufweisen und die Bezeichnungen des Anoden- und Kathodenanschlusses vertauscht sind.

Bei einer Schottkydiode gemäß der Erfindung ist die Dotierkonzentration der n-Epischicht 20 vorzugsweise deutlich höher als in einer konventionellen Hochspannungs-PN-Diode und einer konventionellen Hochspannungs-Schottkydiode.

Eine Schottkydiode gemäß der Erfindung weist in vorteilhafter Weise eine Durchbruchspannung auf, die größer als 100 V ist, vorzugsweise sogar größer als 200 V ist.

Die Gräben 30 können eine rechteckige Form, eine U-Form oder auch eine ähnliche andere Form aufweisen. Sie können in Streifenanordnung oder als Inseln angeordnet sein. Die Inseln können kreisförmig, sechseckig oder auch anders gestaltet sein.

Die Metallisierung auf der Vorderseite und der Rückseite der Schottkydiode ist vorzugsweise lötbar ausgebildet.

Eine Schottkydiode gemäß der Erfindung ist vorzugsweise in einem Einpressdiodengehäuse angeordnet.

Eine Schottkydiode gemäß der Erfindung kann beispielsweise Bestandteil eines Gleichrichters eines Kraftfahrzeuggenerators sein.

In der Figur 3 ist eine weitere Ausführungsform einer erfindungsgemäßen Schottkydiode dargestellt. Im Unterschied zu der in der Figur 2 gezeigten Schottkydiode überbrücken die Schottkykontakte 70, 50a und 50b den gesamten Grabenbereich 30. Zwischen den Schottkykontakten 70 sowie zwischen dem Schottkykontakt 50b und dem benachbarten floatenden Schottkykontakt 70 befinden sich jeweils dielektrische Schichten 80, so dass die einzelnen floatenden Schottkykontakte voneinander und von dem Schottlykonatkt 50b galvanisch getrennt sind. Als dielektrische Schichten finden bevorzugt Oxidschichten Verwendung.

## Patentansprüche

1. Schottkydiode, aufweisend ein n⁺-Substrat (10), eine n-Epischicht (20), in die n-Epischicht (20) eingebrachte Gräben (30), Mesabereiche (40) zwischen benachbarten Gräben (30) und eine Metallschicht (60) an ihrer Rückseite (R), wobei diese Metallschicht (60) als Kathodenelektrode dient, **dadurch gekennzeichnet, dass** eine an ihrer Vorderseite (V) vorgesehene Anodenelektrode zwei Metallschichten (50a,50b) aufweist, von denen die erste Metallschicht (50a) einen Schottky-Kontakt bildet und die zweite Metallschicht (50b) unterhalb der ersten Metallschicht (50a) angeordnet ist und ebenfalls einen Schottky-Kontakt bildet und dass an den Wänden der Gräben (30) zwischen der zweiten Metallschicht (50b) und den Böden der Gräben (30) weitere, floatende Schottky-Kontakte (70) angeordnet sind.

2. Schottkydiode nach Anspruch 1, **dadurch gekennzeichnet, dass** die erste Metallschicht (50a) und die zweite Metallschicht (50b), die jeweils einen Schottky-Kontakt bilden, unterschiedliche Barrierehöhen aufweisen.

3. Schottkydiode nach Anspruch 2, **dadurch gekennzeichnet, dass** die zweite Metallschicht (50b) eine größere Barrierehöhe hat als die erste Metallschicht (50a).

4. Schottkydiode nach einem der vorhergehenden Ansprüche, **dadurch gekennzeichnet, dass** zwischen der zweiten Metallschicht (50b) und dem dieser benachbarten weiteren Schottky-Kontakt (70) und zwischen den weiteren Schottky-Kontakten (70) jeweils ein Abstand (D_gap) vorgesehen ist.

5. Schottkydiode nach Anspruch 4, **dadurch gekennzeichnet, dass** der Abstand (D_gap) zwischen den weiteren Schottky-Kontakten (70) und eine Weite (D_sk) der weiteren Schottky Kontakte jeweils gleich gewählt sind.

6. Schottkydiode nach einem der vorhergehenden Ansprüche, **dadurch gekennzeichnet, dass** die weiteren Schottky-Kontakte (70) jeweils dieselbe Barrierehöhe aufweisen wie die als Schottky-Kontakt dienende zweite Metallschicht (50b).

7. Schottkydiode nach einem der vorhergehenden Ansprüche, **dadurch gekennzeichnet, dass** die Schottkykontakte (50a und 50b) und die weiteren Schottkykontakte (70) sich vollständig längs der Grabenseitenwände erstrecken und dass sich zwischen diesen Schottkykontakten jeweils dielektrische Schichten (80) befinden.

8. Schottkydiode nach einem der vorhergehenden Ansprüche 1 bis 6, **dadurch gekennzeichnet, dass** die Schottkykontakte (50a und 50b) und die weiteren Schottkykontakte (70) den gesamten Grabenbereich (30) überbrücken und dass sich zwischen diesen Schottkykontakten jeweils dielektrische Schichten (80) befinden.

9. Schottkydiode nach einem der vorhergehenden Ansprüche, **dadurch gekennzeichnet, dass** alle ihre Schichten den jeweils entgegengesetzten Leitfähigkeitstyp aufweisen und die Bezeichnungen des Anoden- und des Kathodenanschlusses vertauscht sind.

## Claims

1. Schottky diode, comprising an n⁺-type substrate (10) an n-type epitaxial layer (20), trenches (30) introduced into the n-type epitaxial layer (20), mesaregions (40) between adjacent trenches (30), and a metal layer (60) on its rear side (R), wherein said metal layer (60) serves as a cathode electrode, **characterized in that** an anode electrode provided on its front side (V) comprises two metal layers (50a, 50b), of which the first metal layer (50a) forms a Schottky contact and the second metal layer (50b) is arranged below the first metal layer (50a) and likewise forms a Schottky contact, and **in that** further, floating Schottky contacts (70) are arranged on the walls of the trenches (30) between the second metal layer (50b) and the bottoms of the trenches (30).

2. Schottky diode according to Claim 1, **characterized in that** the first metal layer (50a) and the second metal layer (50b), which in each case form a Schottky contact, have different barrier heights.

3. Schottky diode according to Claim 2, **characterized in that** the second metal layer (50b) has a greater barrier height than the first metal layer (50a).

4. Schottky diode according to any of the preceding claims, **characterized in that** in each case a distance (D_gap) is provided between the second metal layer (50b) and the further Schottky contact (70) adjacent thereto and between the further Schottky contacts (70).

5. Schottky diode according to Claim 4, **characterized in that** the distance (D_gap) between the further Schottky contacts (70) and a width (D_sk) of the further Schottky contacts are chosen to be identical in each case.

6. Schottky diode according to any of the preceding claims, **characterized in that** the further Schottky contacts (70) in each case have the same barrier height as the second metal layer (50b) serving as a Schottky contact.

7. Schottky diode according to any of the preceding claims, **characterized in that** the Schottky contacts (50a and 50b) and the further Schottky contacts (70) extend completely along the trench sidewalls, and **in that** dielectric layers (80) are respectively situated between these Schottky contacts.

8. Schottky diode according to any of the preceding Claims 1 to 6, **characterized in that** the Schottky contacts (50a and 50b) and the further Schottky contacts (70) bridge the entire trench region (30), and **in that** dielectric layers (80) are respectively situated between these Schottky contacts.

9. Schottky diode according to any of the preceding claims, **characterized in that** all its layers have the respective opposite conductivity type and the designations of the anode and cathode terminals are interchanged.

## Revendications

1. Diode Schottky, possédant un substrat n⁺ (10), une couche épitaxiale n (20), des tranchées (30) pratiquées dans la couche épitaxiale n (20), des zones mésa (40) entre des tranchées (30) voisines et une couche métallique (60) sur son côté arrière (R), cette couche métallique (60) servant d'électrode de cathode, **caractérisée en ce qu'**une électrode d'anode prévue sur son côté avant (V) possède deux couches métalliques (50a, 50b), dont la première couche métallique (50a) forme un contact Schottky et la deuxième couche métallique (50b) est disposée au-dessous de la première couche métallique (50a) et forme également un contact Schottky, et **en ce que** des contacts Schottky supplémentaires flottants (70) sont disposés sur les parois des tranchées (30) entre la deuxième couche métallique (50b) et le fond des tranchées (30).

2. Diode Schottky selon la revendication 1, **caractérisée en ce que** la première couche métallique (50a) et la deuxième couche métallique (50b), lesquelles forment respectivement un contact Schottky, présentent des hauteurs de barrière différentes.

3. Diode Schottky selon la revendication 2, **caractérisée en ce que** la deuxième couche métallique (50b) possède une hauteur de barrière supérieure à celle de la première couche métallique (50a).

4. Diode Schottky selon l'une des revendications précédentes, **caractérisée en ce qu'**un écart (D_gap) est respectivement présent entre la deuxième couche métallique (50b) et le contact Schottky supplémentaire (70) voisin de celle-ci et entre les contacts Schottky supplémentaires (70).

5. Diode Schottky selon la revendication 4, **caractérisée en ce que** l'écart (D_gap) entre les contacts Schottky supplémentaires (70) et une largeur (D_sk) des contacts Schottky supplémentaires sont à chaque fois choisis égaux.

6. Diode Schottky selon l'une des revendications précédentes, **caractérisée en ce que** les contacts Schottky supplémentaires (70) présentent respectivement la même hauteur de barrière que la deuxième couche métallique (50b) servant de contact Schottky.

7. Diode Schottky selon l'une des revendications précédentes, **caractérisée en ce que** les contacts Schottky (50a et 50b) et les contacts Schottky supplémentaires (70) s'étendent intégralement le long des parois latérales de tranchée et **en ce que** des couches diélectriques (80) se trouvent respectivement entre ces contacts Schottky.

8. Diode Schottky selon l'une des revendications 1 à 6, **caractérisée en ce que** les contacts Schottky (50a et 50b) et les contacts Schottky supplémentaires (70) enjambent la totalité de la zone de tranchée (30) et **en ce que** des couches diélectriques (80) se trouvent respectivement entre ces contacts Schottky.

9. Diode Schottky selon l'une des revendications précédentes, **caractérisée en ce que** toutes ses couches présentent le type de conductivité respectivement opposé et les désignations de la borne d'anode et de la borne de cathode sont interverties.
